# EUROPÄISCHE PATENTSCHRIFT

(11) **EP 0 818 070 B1**
(45) Veröffentlichungstag und Bekanntmachung des Hinweises auf die Patenterteilung: **25.11.1998**
(21) Anmeldenummer: 96905848.6
(22) Anmeldetag: 01.03.1996
(51) Int. Cl.: H02B 1/01

(54) **SCHALTSCHRANK MIT RAHMENGESTELL UND MONTAGEPLATTE**
SWITCHGEAR CUBICLE WITH FRAME AND FITTING PLATE
ARMOIRE DE DISTRIBUTION ELECTRIQUE AVEC CADRE ET PLAQUE DE MONTAGE

(30) Priorität: 30.03.1995 DE 19511639
(43) Veröffentlichungstag der Anmeldung: 14.01.1998
(73) Patentinhaber: Rittal-Werk Rudolf Loh GmbH & Co. KG, 35745 Herborn (DE)
(72) Erfinder: REUTER, Wolfgang, D-57299 Burbach (DE)
(74) Vertreter: Fleck, Hermann-Josef, Dr.-Ing.
(86) Internationale Anmeldenummer: EP9600872
(87) Internationale Veröffentlichungsnummer: WO9630978

(56) Entgegenhaltungen:
- EP-A- 0 167 833
- DE-A- 4 140 072
- DE-A- 4 312 487

## Beschreibung

Die Erfindung betrifft einen Schaltschrank mit einem aus Rahmenschenkeln zusammengesetzten Rahmengestell, dessen offene Seiten mittels Wandelementen und mindestens einer Schranktüre verschlossen oder verschließbar sind und mit mindestens einer im Abstand und parallel zur Schrankrückseite angeordneten und festgelegten Montageplatte, die bei einem abgenommenen, als Seitenwand verwendeten Wandelement mit ihrer unteren Seite in eine U-förmige Halteschiene einführbar und darin festlegbar ist.

Bei diesem Schaltschrank kann die außerhalb des Schaltschrankes bestückte Montageplatte bei abgenommener Seitenwand mit der unteren Seite in die am Rahmengestell befestigte Halteschiene eingeschoben werden, wobei die Halteschiene eine Führungsaufnahme für die Montageplatte bildet, wie die DE 28 27 262 A1 zeigt. Da die bestückte Montageplatte ein beachtliches Gewicht aufweisen kann, ist dafür Sorge zu tragen, daß sie beim Einführen eindeutig und reibungsarm geführt ist.

In der DE 41 40 072 A1 ist ein Schaltschrank gezeigt, bei dem Montageplatten mit aufgesteckten Gleitstücken auf den unteren Rahmenschenkeln des Rahmengestelles in Richtung der Schaltschranktiefe verschoben werden können.

Aus der DE 43 12 487 A1 geht ein Schaltschrank hervor, in dem eine Montageplatte bei geöffneter Schaltschranktüre von vorne her in den Schaltschrank eingesetzt werden kann. Dabei gleitet die Montageplatte auf zwei Schienen, die sich in Richtung der Schaltschranktiefe erstrecken.

Es ist Aufgabe der Erfindung, bei einem Schaltschrank der eingangs erwähnten Art das Einschieben der Montageplatte in die Halteschiene zu erleichtern und zu verbessern.

Diese Aufgabe wird nach der Erfindung dadurch gelöst, daß die untere und obere Seite der Montageplatte einen einfach abgekanteten horizontalen Rand und die anschließenden vertikalen Seiten der Montageplatte einen doppelt abgekanteten, zur unteren und oberen Seite hin offenen Doppelrand aufweisen, daß Gleitstücke zum Gleiten der Montageplatte längs der U-förmigen Halteschiene vorgesehen sind, und daß in die durch die Doppelränder der Montageplatte gebildeten Aufnahmen Steckansätze von Gleitstücken einführbar sind, die mit Gleitplatten an dem horizontalen Rand der Montageplatte vorstehen.

Durch diese Abkantungen der Montageplatten wird die Anbringung der Gleitstücke vereinfacht und mit der an der unteren bzw. oberen Seite der Montageplatte vorstehenden Gleitplatten wird die Reibung zwischen der Montageplatte und der Halteschiene reduziert. Das Einschieben der bestückten Montageplatte in die U-förmige Halteschiene ist daher einfach durchführbar, wobei die Gleitstücke auch die Beschädigung der Halteschienen vermeiden und das Einschiebegeräusch dämpfen. Die Montageplatte ist in zwei um 180° verdrehten Stellungen verwendbar.

Ist dabei vorgesehen, daß die Gleitplatten der Gleitstücke neben dem Steckansatz einen Rastansatz tragen, der in einen Rastschlitz des horizontalen Randes der Montageplatte einrastbar ist, dann wird der Halt der Gleitstücke an der Montageschiene noch verbessert.

Das Gleiten der Montageplatte in der Halteschiene kann dadurch noch verbessert werden, daß die senkrecht zu der Montageplatte stehenden Seiten der Gleitstücke als abgeschrägte Gleitflächen bilden.

Wird nach einer Ausgestaltung vorgesehen, daß die Rastschlitze durch einen Randabschnitt von den durch die Doppelränder gebildeten Aufnahmen getrennt sind, und daß zwischen den Randabschnitten und den Doppelrändern ein Abstand besteht, dann läßt sich die Montageplatte in bekannter Weise ohne Gleitstücke auch auf vertikalen Führungsstegen verstellen, welche zwischen dem Randabschnitt und dem Doppelrand der Montageplatte einführbar sind.

Die Festlegung der Montageplatte kann nach einer Ausgestaltung dadurch vervollständigt werden, daß auch die obere Seite der Montageplatte in einer Halteschiene geführt und festgelegt ist.

Die obere Seite der eingeschobenen Montageplatte kann aber auch mittels Befestigungsteilen, wie z.B. Befestigungswinkl, an Rahmenschenkeln, vorzugsweise an als Tiefenstreben verwendeten Rahmenschenkeln, angebracht werden. Die untere Halteschiene ist an den als Tiefenstreben des Rahmengestelles verwendeten, unteren Rahmenschenkeln befestigt.

Der Einbau der Halteschienen wird dadurch ermöglicht, daß die Halteschienen an ihren Enden Befestigungslaschen aufweist, die im Bereich des Basisschenkels der Halteschiene seitlich an einem Seitenschenkel derselben abstehen und an horizontal ausgerichteten Befestigungsflächen der zugekehrten Rahmenschenkel oder parallel dazu verlaufender Zusatzschienen befestigt sind.

Die Stellung der eingeschobenen Montageplatte wird dadurch fixiert, daß der dem als Rückwand verwendeten Wandelement zugekehrte Seitenschenkel der Halteschienen höher ist als der der Rückwand abgekehrte Seitenschenkel und daß die Montageplatte in ihren Eckbereichen mit Bohrungen für Befestigungsschrauben versehen ist, die in der eingeschobenen Stellung der Montageplatte mit Schraubaufnahmen des der Rückwand zugekehrten Seitenschenkels der Halteschienen oder Befestigungsteilen fluchten.

Die Erfindung wird anhand eines in den Zeichnungen dargestellten Ausführungsbeispiels näher erläutert. Es zeigen:
- Fig. 1: in perspektivischer Ansicht ein Rahmengestell eines Schaltschrankes mit einer eingebauten Halteschiene für die untere Seite einer Montageplatte,
- Fig. 2: eine Teilansicht eines unteren Eckbereiches einer Montageplatte mit Gleitstück und
- Fig. 3: eine Teilansicht des unteren Bereiches des Rahmengestelles mit eingebauter Montageschiene.

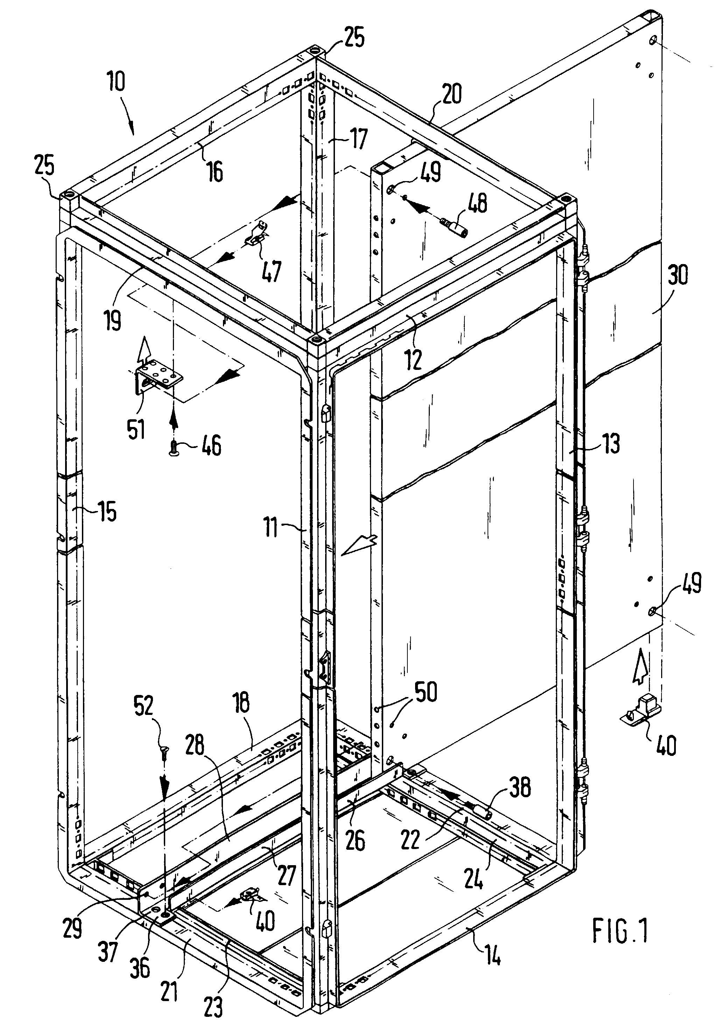

In Fig. 1 ist von dem Schaltschrank nur das Rahmengestell 10 gezeigt, wobei die Wandelemente und die Schranktüre abgenommen sind. Das Rahmengestell 10 ist aus Rahmenschenkeln 11 bis 22 zusammengesetzt, wobei in den Ecken Eckverbinder 25 die Verbindung der aufeinanderstoßenden Rahmenschenkel übernehmen. Dabei können die Rahmenschenkel 11 bis 14 und die Rahmenschenkel 15 bis 18 jeweils einen Rahmen bilden, die über als Tiefenstreben verwendete Rahmenschenkel 19 bis 22 miteinander verbunden oder verbindbar sind.

Zwischen den als untere Tiefenstreben verwendeten Rahmenschenkeln 21 und 22 ist eine nach oben offene U-förmige Halteschiene 26 befestigt, die an ihren Enden Befestigungslaschen 36 mit Befestigungsbohrungen 37 trägt. Diese Befestigungslaschen 36 liegen in der Ebene des Basisschenkels der Halteschiene 26 und stehen an dem Seitenschenkel 27 der Halteschiene 26 horizontal ab. Mit Befestigungsschrauben 52 kann die Halteschiene 26 an horizontalen Befestigungsflächen der Rahmenschenkel 21 und 22 oder auch an parallel dazu angeordneten Zusatzschienen 23 und 24 angeschraubt werden. Die Montageschiene 30 wird von einer Seite her in die Halteschiene 26 eingeschoben, wobei die Halteschiene 26 mit ihren Seitenschenkeln 27 und 28 eine Führungsaufnahme für die Montageplatte 30 bildet.

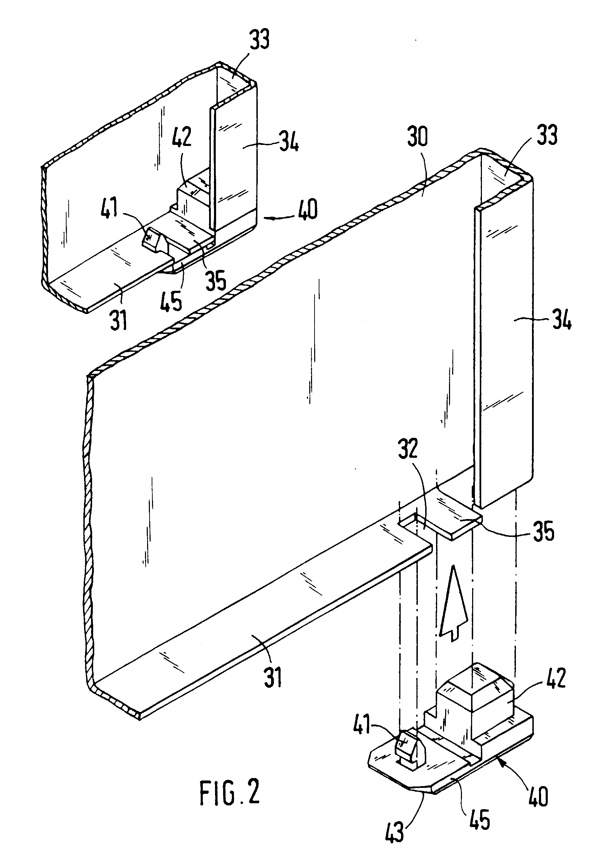

Wie die Fig. 2 zeigt, ist die untere und die (nicht gezeigte) obere Seite der Montageplatte 30 mit einem einfach abgekanteten, horizontalen Rand 31 versehen, während die senkrechten Seiten doppelt abgekantet sind und mit ihren Randabschnitten 33 und 34 einen Doppelrand bilden, der zur unteren und oberen Seite der Montageplatte 30 hin eine offene Aufnahme bildet. In diese Aufnahme kann ein Steckansatz 42 eines Gleitstückes 40 eingeführt werden, das mit einer Gleitplatte 45 an dem horizontalen Rand 31 vorsteht. Der Rand 31 beginnt im Abstand zu dem Doppelrand (Randabschanitte 33 und 34) mit einem Randabschnitt 35 und einem Rastschlitz 32, in den ein Rastansatz 41 des Gleitstückes 40 eingerastet werden kann. Die senkrecht zur Montageplatte 30 verlaufenden Seiten der Gleitplatte 45 sind abgeschrägt, wie die Gleitschräge 43 erkennen läßt, um die Gleitbewegung des Gleitstückes 40 in der Halteschiene 26 nicht zu beeinträchtigen. An allen Ecken der Montageplatte 30 lassen sich derartige Gleitstücke 40 festlegen, so daß die Montageschiene 30 auch um 180° verdreht in die Halteschiene 26 eingeführt werden kann oder auch mit der oberen Seite in gleicher Weise in einer Halteschiene 26 geführt und festgelegt werden kann. Der horizontale Rand 31 und der vertikale Doppelrand (Randabschnitte 33 und 34) bringen eine zusätzliche Versteifung der Montageplatte 30 und sind an die durch die Seitenschenkel 27 und 28 der Halteschiene 26 gebildete Führungsaufnahme angepaßt.

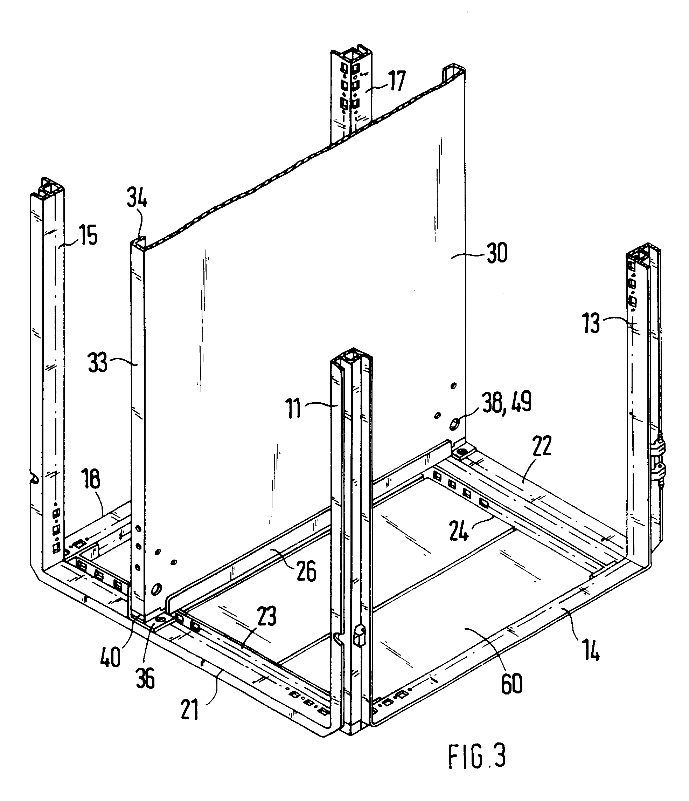

Wie der Fig. 1 zusätzlich zu entnehmen ist, ist der der Vorderseite des Schaltschrankes mit der Schranktür zugekehrte Seitenschenkel 27 der Halteschiene 26 niedriger als der der Rückwand zugekehrte Seitenschenkel 28. In den Eckbereichen trägt die Montageplatte 30 Bohrungen 49 für Befestigungsschrauben 38 und 48, die bei eingeschobener Montageplatte 30 mit Schraubaufnahmen 29 im Seitenschenkel 28 der Halteschiene 26 fluchten und zur Fixierung der Montageplatte 30 in der Einbaustellung dienen, wie Fig. 3 zeigt.

In gleicher Weise kann die obere Seite der Montageplatte 30 in einer nach unten offenen Halteschiene geführt und fixiert werden. Anstelle der oberen Halteschiene können an den als Tiefenstreben verwendeten, oberen Rahmenschenkeln 19 und 20 als Befestigungswinkel ausgebildete Befestigungsteile 51 verwendet werden, die mittels Schrauben 46 und Steckmuttern 47 an den Rahmenschenkeln 19 und 20 angebracht sind. Die Bohrungen 49 für die Befestigungsschrauben 48 der Montageplatte 30 fluchten dann mit Schraubaufnahmen der Befestigungswinkel. Die Montageplatte 30 ist mit zusätzlichen Montagebohrungen 50 versehen.

Die Bodenseite des Rahmengestelles 10 wird mit Bodenplatten 60 verschlossen.

## Patentansprüche

1. Schaltschrank mit einem aus Rahmenschenkeln (11 bis 22) zusammengesetzten Rahmengestell (10), dessen offene Seiten mittels Wandelementen und mindestens einer Schranktüre verschlossen oder verschließbar sind und mit mindestens einer im Abstand und parallel zur Schrankrückseite angeordneten und festgelegten Montageplatte (30), die bei einem abgenommenen, als Seitenwand verwendeten Wandelement mit ihrer unteren Seite in eine U-förmige Halteschiene (26) einführbar und darin festlegbar ist,
dadurch gekennzeichnet,
daß die untere und obere Seite der Montageplatte (30) einen einfach abgekanteten horizontalen Rand (31) und die anschließenden vertikalen Seiten der Montageplatte (30) einen doppelt abgekanteten, zur unteren und oberen Seite hin offenen Doppelrand (33,34) aufweisen,
daß Gleitstücke (40) zum Gleiten der Montageplatte (30) längs der U-förmigen Halteschiene (26) vorgesehen sind, und
daß in die durch die Doppelränder (33,34) der Montageplatte (30) gebildeten Aufnahmen Steckansätze (42) von Gleitstücken (40) einführbar sind, die mit Gleitplatten (45) an dem horizontalen Rand (31) der Montageplatte (30) vorstehen.

2. Schaltschrank nach Anspruch 1,
dadurch gekennzeichnet,
daß die Gleitplatten (45) der Gleitstücke (40) neben dem Steckansatz (42) einen Rastansatz (41) tragen, der in einen Rastschlitz (32) des horizontalen Randes (31) der Montageplatte (30) einrastbar ist.

3. Schaltschrank nach Anspruch 1 oder 2,
dadurch gekennzeichnet,
daß die senkrecht zu der Montageplatte (30) stehenden Seiten der Gleitstücke (40) als abgeschrägte Gleitflächen (43) bilden.

4. Schaltschranknach einem der Ansprüche 1 bis 3,
dadurch gekennzeichnet,
daß die Rastschlitze (32) durch einen Randabschnitt (35) von den durch die Doppelränder (33,34) gebildeten Aufnahmen getrennt sind, und daß zwischen den Randabschnitten (35) und den Doppelrändern (33,34) ein Abstand besteht.

5. Schaltschrank nach einem der Ansprüche 1 bis 4,
dadurch gekennzeichnet,
daß auch die obere Seite der Montageplatte (30) in einer Halteschiene geführt und festgelegt ist.

6. Schaltschrank nach einem der Ansprüche 1 bis 4,
dadurch gekennzeichnet,
daß die obere Seite der Montageplatte (30) mittels Befestigungsteilen (51) an Rahmenschenkeln, vorzugsweise an als Tiefenstreben verwendeten Rahmenschenkeln (19,20) angebracht ist.

7. Schaltschrank nach einem der Ansprüche 1 bis 5,
dadurch gekennzeichnet,
daß die untere Halteschiene (26) an den als Tiefenstreben verwendeten unteren Rahmenschenkeln (21,22) befestigt ist.

8. Schaltschrank nach einem der Ansprüche 1 bis 7,
dadurch gekennzeichnet,
daß die Halteschienen (26) an ihren Enden Befestigungslaschen (36) aufweist, die im Bereich des Basisschenkels der Halteschiene (26) seitlich an einem Seitenschenkel (z.B. 27) derselben abstehen und an horizontal ausgerichteten Befestigungsflächen der zugekehrten Rahmenschenkel (19,20, 21,22) oder parallel dazu verlaufender Zusatzschienen (23,24) befestigt sind.

9. Schaltschrank nach einem der Ansprüche 1 bis 8,
dadurch gekennzeichnet,
daß der dem als Rückwand verwendeten Wandelement zugekehrte Seitenschenkel (28) der Halteschienen (26) höher ist als der der Rückwand abgekehrte Seitenschenkel (27) und
daß die Montageplatte (30) in ihren Eckbereichen mit Bohrungen (49) für Befestigungsschrauben (38,48) versehen ist, die in der eingeschobenen Stellung der Montageplatte (30) mit Schraubaufnahmen (29) des der Rückwand zugekehrten Seitenschenkels (28) der Halteschienen (26) oder Befestigungsteilen (51) fluchten.

## Claims

1. Switchgear cabinet, including a framework (10), which comprises frame members (11 to 22) and has open sides which are sealed or sealable by means of wall members and at least one cabinet door, and including at least one mounting plate (30), which is disposed and secured at a spacing from and parallel to the rear cabinet side, said plate being insertable in a U-shaped retaining bar (26) by its lower side and securable therein when a wall member which is used as a lateral wall has been removed, characterised in that the lower and upper sides of the mounting plate (30) have a singly bent horizontal edge (31), and the communicating vertical sides of the mounting plate (30) have a doubly bent double edge (33,34), which is open towards the lower and upper sides, in that sliders (40) are provided for sliding the mounting plate (30) along the U-shaped retaining bar (26), and in that extensions (42) of sliders (40) are insertable in the receivers formed by the double edges (33,34) of the mounting plate (30), which sliders protrude with slide plates (45) beyond the horizontal edge (31) of the mounting plate (30).

2. Switchgear cabinet according to claim 1, characterised in that the slide plates (45) of the sliders (40) support, in addition to the extension (42), a locking extension (41) which can be locked in position in a locking slot (32) in the horizontal edge (31) of the mounting plate (30).

3. Swltchgear cabinet according to claim 1 or 2, characterised in that the sides of the sliders (40), which lie perpendicular to the mounting plate (30), are formed as chamfered slide faces (43).

4. Switchgear cabinet according to one of claims 1 to 3, characterised in that the locking slots (32) are separated, by an edge portion (35), from the receivers which are formed by the double edges (33,34), and in that there is a spacing between the edge portions (35) and the double edges (33,34).

5. Switchgear cabinet according to one of claims 1 to 4, characterised in that the upper side of the mounting plate (30) is also guided and secured in a retaining bar.

6. Switchgear cabinet according to one of claims 1 to 4, characterised in that the upper side of the mounting plate (30) is mounted on frame members, preferably on frame members (19,20) which are used as depth bars, by means of securing members (51).

7. Switchgear cabinet according to one of claims 1 to 5, characterised in that the lower retaining bar (26) is secured on the lower frame members (21,22) which are used as depth bars.

8. Switchgear cabinet according to one of claims 1 to 7, characterised in that the retaining bars (26) have, at their ends, securing lugs (36) which, in the region of the base portion of the retaining bar (26), protrude laterally from a lateral portion (e.g. 27) thereof and are secured on horizontally orientated securing faces of the facing frame members (19,20, 21,22) or additional bars (23,24) extending parallel thereto.

9. Switchgear cabinet according to one of claims 1 to 8, characterised in that the lateral portion (28) of the retaining bars (26), which faces the wall member used as the rear wall, is higher than the lateral portion (27) facing away from the rear wall, and in that the mounting plate (30) is provided in its corner regions with bores (49) for securing screws (38,48) which, when the mounting plate (30) is in its inserted position, are in alignment with screw receivers (29) of the lateral portion (28) of the retaining bars (26) or securing members (51) facing the rear wall.

## Revendications

1. Armoire de distribution électrique avec une ossature (10) constituée par des ailes d'encadrement (11 à 22), ossature dont les côtés ouverts sont ou peuvent être fermés au moyen d'éléments de paroi et d'au moins une porte d'armoire et avec au moins une plaque de montage (30) disposée et assujettie parallèlement et à distance de la face arrière de la porte d'armoire, plaque de montage (30) qui dans le cas d'un élément de paroi déposé et utilisé en tant que paroi latérale peut être engagée par son côté inférieur dans un rail de montage en forme de U (26) et peut y être assujetti,
caractérisée
en ce que le côté inférieur et supérieur de la plaque de montage (30) présente un bord coudé horizontal (31) et en ce que les côtés verticaux contigus de la plaque de montage (30) présentent un bord double (33, 34) à double coude, ouvert en direction du côté supérieur et en direction du côté inférieur,
en ce que sont prévus des coulisseaux (40) pour le glissement de plaque de montage (30) le long du rail de support (26) en forme de U, et
en ce qu'au travers les logements constitués par les bords doubles (33, 34) de la plaque de montage (30) peuvent être introduits des épaulements d'enfichage (42) de coulisseaux (40), épaulements d'enfichage qui par des plaques de glissement (45) font protubérance sur le bord horizontal (31) de la plaque de montage (30).

2. Armoire de distribution électrique suivant la revendication 1,
caractérisée
en ce qu'à côté de l'épaulement d'enfichage (42), les plaques de glissement (45) des coulisseaux (40) portent un épaulement d'encliquetage (41), qui peut être encliqueté dans une fente d'encliquetage (32) du bord horizontal (31) du rail de montage (30).

3. Armoire de distribution électrique suivant la revendication 1 ou 2,
caractérisée
en ce que les côtés des coulisseaux (40) perpendiculaires à la plaque de montage (30) constituent des faces de glissement biseautées (43).

4. Armoire de distribution électrique suivant l'une quelconque des revendications de 1 à 3,
caractérisée
en ce que les fentes d'encliquetage (32) sont séparées des logements (33, 34) constitués par les bords doubles par un tronçon marginal (35), et
en ce qu'une distance est prévue entre les tronçons marginaux (35) et les bords doubles (33, 34).

5. Armoire de distribution électrique suivant l'une quelconque des revendications de 1 à 4,
caractérisée
en ce que le côté supérieur de la plaque de montage (30) est lui aussi guidé et assujetti dans un rail de support.

6. Armoire de distribution électrique suivant l'une quelconque des revendications de 1 à 4,
caractérisée
en ce que le côté supérieur de la plaque de montage (30) est au moyen d'éléments de fixation (51) fixé à des ailes d'encadrement, de préférence à des ailes d'encadrement (19, 20) faisant fonction d'entretoises de profondeur.

7. Armoire de distribution électrique suivant l'une quelconque des revendications de 1 à 5,
caractérisée
en ce que le rail de support inférieur (26) est fixé aux ailes d'encadrement inférieures (21, 22) faisant fonction d'entretoises de profondeur.

8. Armoire de distribution électrique suivant l'une quelconque des revendications de 1 à 7,
caractérisée
en ce que les rails de support (26) présentent à leurs extrémités des pattes de fixation (36), qui dans la région de l'aile de base du rail de support (26) font protubérance latéralement sur une aile latérale (par exemple 27) du rail et qui sont fixées à des surfaces orientées horizontalement des ailes d'encadrement contigus (19, 20, 21, 22) ou à des rails additionnels (23, 24) parallèles à ces ailes d'encadrement.

9. Armoire de distribution électrique suivant l'une quelconque des revendications de 1 à 8,
caractérisée
en ce que l'aile latérale (28) des rails de support (26) qui est orientée vers l'élément de paroi faisant fonction de paroi arrière est plus haute que l'aile latérale (27) qui n'est pas orientée vers la paroi arrière, et
en ce que dans ses zones d'angle, la plaque de montage (30) présente des forures (49) pour des vis de fixation (38, 48), forures qui lorsque la plaque de montage (30) est mise en place sont en alignement avec des logements récepteurs (29) de l'aile latérale (28) des rails de support (26) orientée vers la paroi arrière ou avec des logements récepteurs des éléments de fixation (51).
